(19) **Europäisches Patentamt**
**European Patent Office**
**Office européen des brevets**

(11) **EP 1 830 470 B1**

(12) **EUROPEAN PATENT SPECIFICATION**

(45) Date of publication and mention
of the grant of the patent:
**24.02.2010 Bulletin 2010/08**

(51) Int Cl.:
***H03M 1/48*** *(2006.01)*

(21) Application number: **07468002.6**

(22) Date of filing: **21.02.2007**

(54) **Circuit for position determination by means of a sine and cosine signal**

Schaltkreis zur Positionsbestimmung über ein Sinus- und ein Kosinus-Signal

Circuit pour la détermination de position à l'aide de signaux sinusoïdaux et cosinusoïdaux

(84) Designated Contracting States:
**AT BE BG CH CY CZ DE DK EE ES FI FR GB GR HU IE IS IT LI LT LU LV MC NL PL PT RO SE SI SK TR**

(30) Priority: **01.03.2006 SI 200600039**

(43) Date of publication of application:
**05.09.2007 Bulletin 2007/36**

(73) Proprietor: **Univerza v Ljubljani FAKULTETA ZA ELEKTROTEHNIKO 1000 Ljubljana (SI)**

(72) Inventors:
• **Trontelj, Janez 1000 Ljubljana (SI)**

• **Sesek, Aleksander 1234 Menges (SI)**

(74) Representative: **Gros, Mladen Patentna pisarna d.o.o. Copova 14 P.O. Box 1725 1001 Ljubljana (SI)**

(56) References cited:
**EP-A- 1 594 223     EP-A2- 0 853 231
WO-A-02/18881       DE-A1- 10 014 056
DE-A1- 19 548 385   JP-A- 3 075 575
US-A- 4 468 618     US-A- 4 511 830
US-A1- 2002 024 399**

## Description

The invention relates to a circuit for position determination by means of a sine and cosine analogue signal.

There is known a complex circuit for correcting periodic signals of an incremental position measuring system (DE 100 14 056 A1). Said sine-shaped and cosine-shaped signals are conducted to the inputs of a first circuit in which a segmentation of said signals takes place by uninterruptedly generating a segmented signal from a time dependence function of that one of the first input signal and the second input signal which has a higher voltage at the moment of said generating. Said segmented signal is conducted to a second circuit in which it is compared to several predetermined threshold values in order to determine to which extent said periodic signals must be corrected.

There is known an interpolation device for position determination by means of two sine-shaped analogue signals in quadrature to each other (DE 195 44 948 A1). The device performs a digital interpolation. Therefore the input analogue signals are digitized. In order to achieve N states of a digital signal, N-1 precision comparators are needed. However, an attainable number N is limited by the offset voltage of said comparators and hence also the accuracy of the position determination is restricted.

The invention solves the technical problem how to make a simple but at the same time precise circuit for position determination by means of a sine and a cosine analogue signal.

The said technical problem is solved by the circuit of the invention for position determination by means of the sine and cosine analogue signal as characterized by the features of the characterizing portion of the first claim, and the variants of the embodiment are characterized by dependent claims.

Since the circuit of the invention for position determination needs just three precision comparators, namely in a circuit for a first segmentation, it is, when made as an integrated circuit on a silicon wafer, is smaller than a known circuit with the same 10-bit accuracy in which several hundred precision comparators are used.

The invention will now be explained in more detail by way of the description of an embodiment and with reference to the accompanying drawing representing in

Fig. 1   a circuit of the invention for position determination by means of a sine and a cosine analogue signal,

Fig. 2   a circuit of the invention for a first segmentation of the input sine and cosine signal,

Fig. 3   a circuit of the invention for a further segmentation of intermediate signals,

Fig. 4   a circuit of the invention for a generation of a capacitor charging current,

Fig. 5   a time dependence of the two input signals and two intermediate signals and

Fig. 6   a time dependence of the voltage across the capacitor.

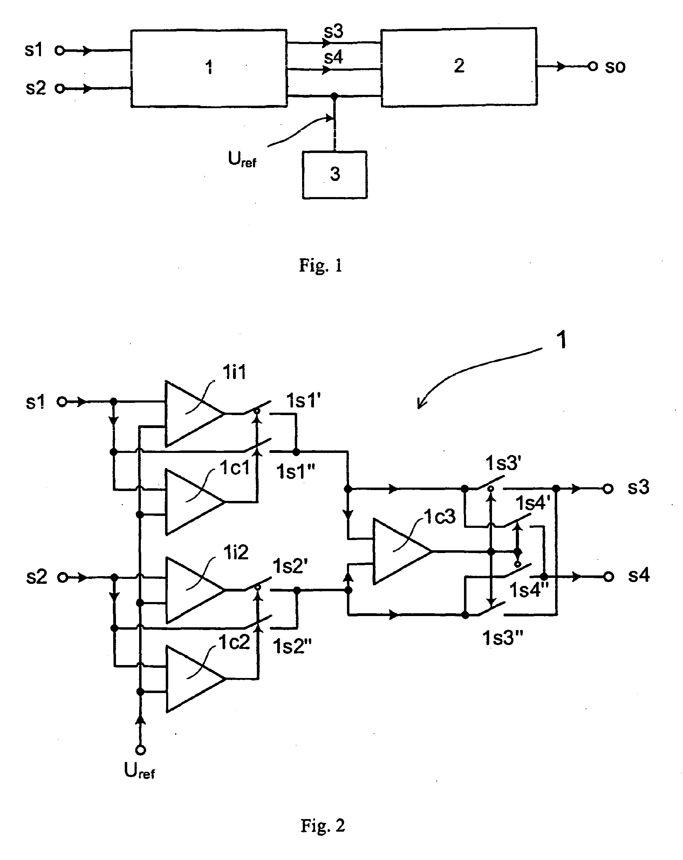

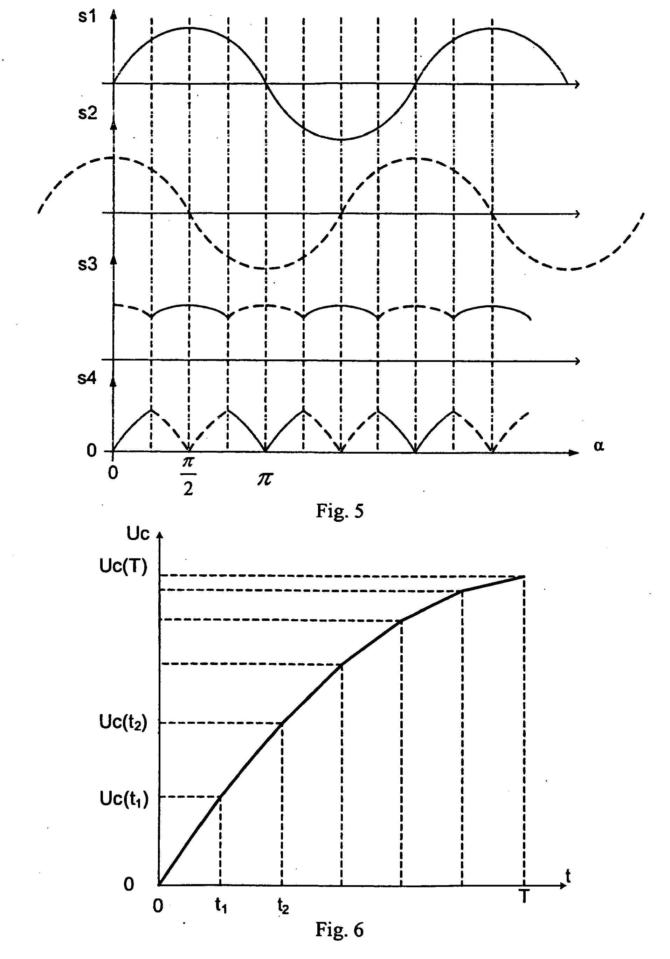

A circuit of the invention for position determination by means of two analogue sine signals s1 and s2 in quadrature to each other consists of a circuit 1 for a first segmentation, to whose inputs the first signal s1 being sine-shaped and the second signal s2 being cosine-shaped are conducted, and of a circuit 2 for a second segmentation, to whose inputs an intermediate third signal s3 and an intermediate fourth signal s4, both from the outputs of the circuit 1 for the first segmentation, are conducted (Figs. 1 and 5). The phase angle $\alpha$ of said signals is plotted on the abscissa of a graph in Fig. 5.

From a voltage generator 3 a reference voltage Uref, which equals a mean value of the first signal s1 or the second signal s2, is supplied to the circuits 1 and 2. In the circuit 2 for the second segmentation uninterruptedly a position signal so is generated, said signal being the output signal of the circuit of the invention.

The circuit 1 for the first segmentation uninterruptedly generates the third signal s3 from a time dependence function of that one of the first signal s1 and the second signal s2, which has a higher voltage at the moment, and the fourth signal s4 from a time dependence function of that one of the first signal s1 and the second signal s2, which has a lower voltage at the moment (Fig. 5).

A possible embodiment of the circuit 1 for the first segmentation is represented in Fig. 2. The first input signal s 1 is conducted to the upper input of a first analogue inverter 1i1 and to the upper input of a first analogue comparator 1c1, to their lower inputs, however, a reference voltage Uref is conducted. In the same way, the second input signal s2 is conducted to the upper input of a second analogue inverter 1i2 and to the upper input of a second analogue comparator 1c2, to their lower inputs, however, a reference voltage Uref is conducted. The analogue inverters 1i1 and 1 i2 are differential amplifiers having the gain equal to -1 and a low offset voltage. To further processing the first input signal s1 and the second input signal s2 are conducted through a second controlled switch 1s1" and a fourth controlled switch 1s2", respectively, which are controlled by the output signal of the first analogue comparator 1c1 and by the output signal of the second analogue comparator 1c2, respectively, or the output signal of the first analogue inverter 1i1 and the output signal of the second analogue inverter 1i2 are conducted through a first controlled switch 1s1' and a third controlled switch 1s2', respectively, which are controlled by the output signal of the first analogue comparator 1c1 and by the output signal of the second analogue comparator 1c2, respectively. Resulting signals are conducted to the terminals of a third analogue comparator 1c3 as well to the first terminal of a fifth switch 1s3' and a sixth switch 1s3", respectively, which are controlled by the inverted output signal of the third analogue comparator 1c3 and by the output signal of the third analogue comparator 1c3, respectively, and to the the first terminal of a seventh switch 1s4' and an eighth switch 1s4", respectively, which are controlled by the output signal of the third analogue comparator 1c3 and by the inverted output signal of the third analogue comparator 1c3, respectively. The second terminals of the fifth switch 1s3' and the sixth switch 1s3" are connected to the first output of the circuit 1 for the first segmentation, where the third signal s3 is output, the second terminals of the seventh switch 1s4' and the eighth switch 1s4", however, are connected to the second output of the circuit 1 for the first segmentation, where the fourth signal s4 is output.

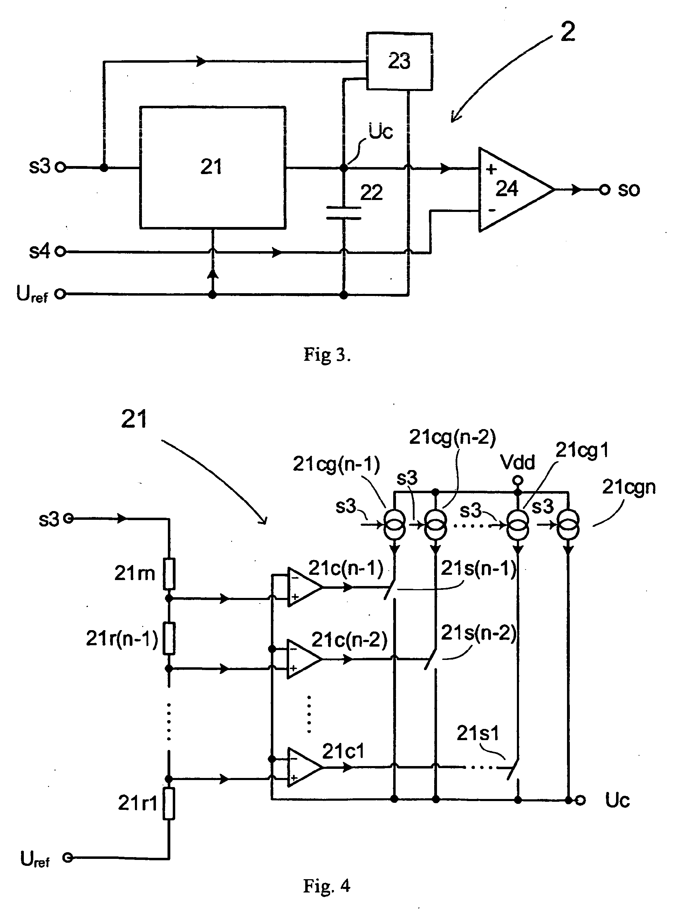

The circuit 2 for the second segmentation is represented in Fig. 3. It consists of a circuit 21 for a charging current generation, to whose input the third signal s3 is conducted, a capacitor 22, to whose upper terminal the output Uc of the circuit 21 for the charging current generation is connected, which circuit each time in an equally long time period T charges the capacitor 22 to the voltage of the signal s3, an adaptive timer 23 which triggers the discharging of the capacitor 22, and a comparator 24, to whose upper terminal the output Uc of the circuit 21 for the charging current generation is connected and to whose lower terminal the fourth signal s4 is conducted. The comparator 24 uninterruptedly performs the comparison and not just in discrete moments of time. The position value is obtained as $\dfrac{\pi}{4} \cdot \dfrac{T'}{T}$ where T' is a time period which each time passed from the beginning of the charging of the capacitor 22 up to a moment of time when the voltage Uc across the capacitor 22 reached the voltage of the fourth signal s4 at the moment. Hence, a pulse-width modulated position signal so is generated, which is the output signal of the circuit of the invention. Indeed, the presented circuit is suitable for position determination in the phase angle interval from 0 to $\dfrac{\pi}{4}$, however, it can be completed in a way known to a person skilled in the art in a way that it can be used in the phase angle interval from 0 to $2\pi$.

The circuit 21 of the invention generates the charging current having such time dependence that in each charging cycle the voltage across the capacitor 22 increases linearly during time intervals, the border points 0, Uc(t1), Uc(t2), ... Uc(T) defining said time intervals, however, are situated on a sine curve (Fig. 6). The circuit 21 for the charging current generation as defined below in more detail provides that all time intervals t1, t2-t1, ... of said time intervals are of equal time duration. The circuit 21 also provides that T and Uc(T) have the same value all the time, irrespective of the phase angle α of the input first and second signal s1, s2.

The circuit 21 for the charging current generation is represented in Fig. 4. It consists of a chain of n resistors 21r1, ... 21r(n-1), 21rn having a total resistance R and to whose upper terminal the third signal s3 is conducted, of comparators 21c1, ... 21c(n-2), 21c(n-1) to whose upper terminal an each time corresponding intermediate common terminal of two adjacent resistors in the chain is connected, of current generators 21cg1, ... 21cg(n-2), 21cg(n-1), 21cgn, which are connected to a supply Vdd and are controlled by the third signal s3 and the current of which generators is drawn through the output Uc of the circuit 21 for the charging current generation, whereat the lower terminals of the comparators 21c1, ... 21c(n-2), 21c(n-1) are connected to said output Uc, and of switching transistors functioning as switches 21s1, ... 21s(n-2), 21s(n-1), which transfer a current each time from a corresponding one of the current generators 21cg1, ... 21cg(n-2), 21cg(n-1), whereat the current from the last current generator 21 cgn flows during the whole charging period and determines an inclination of the last linear section of the time dependence Uc(t) just before t = T. The lower terminal of the chain of the resistors 21r1, ... 21r(n-1), 21rn and the lower terminal of the capacitor 22 are connected to the reference voltage Uref.

In the chain of the resistors n such resistors 21r1, ... 21r(n-1), 21rn are connected that the total resistance of i lowest resistors 21r1, ..., 21ri is equal to

$$R \cdot \sin \dfrac{\pi}{4} \cdot \dfrac{i}{n}.$$

The switches 21s1, ... 21s(n-2), 21s(n-1) are each time controlled by the output signal of the corresponding comparator 21c1, ... 21c(n-2), 21c(n-1) in a way that the individual switch 21s1, ... 21s(n-2), 21s(n-1) opens when the voltage at the output Uc reaches the voltage of the corresponding terminal in the chain of the resistors.

The currents of the current generators 21cg1, ... 21cg(n-2), 21cg(n-1), 21cgn are weighted with regard to each other so that in each charging cycle the current charging the capacitor 22 changes in a way that it is constant in the time intervals which are defined by border points of said time intervals, said border points being situated on a cosine curve. Hereby a sine-shaped increase of the voltage across the capacitor 22 is made possible.

The adaptive timer 23 triggers the discharge of the capacitor 22 down to the reference voltage Uref each time when the voltage Uc across the capacitor 22 has reached the instantaneous voltage of the third signal s3. To this end, the third signal s3 is conducted to the first input and the upper terminal Uc of the capacitor 22 is connected to its second input and the output of the adaptive timer 23 is connected to the reference voltage Uref.

The capacitance of the capacitor 22 and the currents from the current generators 21cg1, ... 21cg(n-2), 21cg(n-1), 21cgn are adjusted in a way that a time interval between two successive discharges of the capacitor 22 is for at least two orders of magnitude shorter than the period of the first input signal s1 or the second input signal s2. The charging of the capacitor 22 and hereby the generation of the voltage across the capacitor 22 being the reference function for the time development of the fourth signal s4 then repeats itself so quickly that the voltage of the signal s3 remains unchanged during the charging cycle of the capacitor 22.

The accuracy of the position determination is determined by the number n of the resistors 21r1, ... 21r(n-1), 21rn in the resistor chain and by the number of said time intervals obtained thereby. The highest deviation amounts to 0,0625° at the phase angle 45°- 45°/8/2. A high accuracy is achieved already at five time intervals. And the accuracy is above 10 bits at eight time intervals. However, this is also a limitation set by the technology of the integrated circuits fabrication.

**Claims**

1. Circuit for position determination by means of a first signal (s1), being sine-shaped, and a second signal (s2), being cosine-shaped,

   said first and second signals (s1, s2) are coupled to respective inputs of a first segmentation circuit (1) for a first segmentation of said first and second signals (s1, s2),

   said first segmentation circuit (1) uninterruptedly generates a third signal (s3), said third signal (s3) takes the value of the highest voltage, at any point in time, of said first and second signals (s1, s2) at the moment wherein the third signal (s3) is generated;

   **characterized in that**

   said first segmentation circuit (1) uninterruptedly generates a fourth signal (s4),

   said fourth signal (s4) takes the value of the lowest voltage, at any point in time, of said first and second signals (s1, s2) at the moment wherein the fourth signal (s4) is generated;

   said third and fourth signals (s3, s4) are coupled to respective inputs of a second segmentation circuit (2) for a segmentation of said third and fourth signals (s3, s4);

   said second segmentation circuit (2) generates a position signal (so) and

   consists of

   a charging current generation circuit (21) for generating charging current,

   said charging current generation circuit (21) consists of

   a chain of n resistors (21r1, ... 21r(n-1), 2lrn), where n is an integer, having a total resistance R and in which the total resistance of i lowest resistors (21rl, ..., 21ri), where i an integer, is equal to $R.\sin(\dfrac{\pi}{4} \cdot \dfrac{i}{n})$

and said third signal (s3) is coupled to an upper terminal of said chain of n resistors (21r1, ... 21r(n-1), 21rn);

a plurality of comparators (21c1, ... 2 1 c(n-2), 21c(n-1)),

each intermediate terminal between adjacent resistors of said chain of n resistors (21r1, ... 21r(n-1), 21rn) is coupled to a respective upper terminal of respective one of said plurality of comparators (21c1, ... 2 1 c(n-2), 21c(n-1));

a plurality of current generators (21cg1, ... 21cg(n-2), 21cg(n-1), 21cgn) which are connected to a supply voltage (Vdd), which are controlled by the third signal (s3) and which generate weighted currents, said weighted currents are drawn through an output (Uc) of said charging current generation circuit (21);

said output (Uc) of said charging current generation circuit (21) is connected to lower terminals of each one of said plurality of comparators (21c1, ... 21 c(n-2), 21c(n-1));

a plurality of respective switches (21s1, ... 21s(n-2), 21s(n-1)), transferring said weighted currents to said output (Uc) of said charging current generation circuit (21) for each time interval from the corresponding current generator;

and said weighted currents are each time controlled by an output signal of said corresponding comparator in a way that the respective switch opens when the voltage at the output (Uc) of said charging current generation circuit (21) reaches the voltage of the corresponding intermediate terminal of said chain of n resistors (21l1, ... 21r(n-1), 21m);

said charging current generation circuit (21) operates to produce said charging current to form a cosine shaped charging current having charging cycles of equal duration for charging a capacitor (22), and border points (0, Uc(t1), Uc(t2) ...) defining said time intervals have charging current values such as to form said cosine shaped charging current;

said second segmentation circuit (2) further consists of said capacitor (22),

an upper terminal of said capacitor (22) is coupled to said output (Uc) of said charging current generation circuit (21);

an adaptive timer (23) discharging said capacitor (22) each time when said voltage at the output (Uc) of said charging current generation circuit (21) reaches the instantaneous voltage of the third signal (s3);

and a further comparator (24) generating said position signal (so), an upper terminal of said further comparator (24) receives the output voltage at the output (Uc) of said charging current generation circuit (21) and a lower terminal of said further comparator (24) receives said fourth signal (s4).

2. The circuit for position determination of claim 1, wherein a lowest terminal of said chain of n resistors (21r1, ... 21r(n-1), 21rn) and a lower terminal of said capacitor (22) are connected to a reference voltage (Uref), which is equal to the mean value of said first signal (s1) or said second signal (s2).

3. The circuit for position determination of claim 2, wherein the capacitance of said capacitor (22) and the weighted currents are adjusted in a way that a time interval between two successive discharges of said capacitor (22) is at least two orders of magnitude shorter than a period of said first signal (s1) or said second signal (s2).


**Patentansprüche**

1. Schaltkreis zur Positionsbestimmung über ein erstes sinusförmiges Signal (s1) und ein zweites kosinusförmiges Signal (s2),
die genannten erstes und zweites Signal (s1, s2) sind an betreffende Eingänge eines ersten Segmentationsschaltkreises (1) für eine erste Segmentation der genannten ersten und zweiten Signales (s1, s2) gekoppelt,
der genannte erste Segmentationsschaltkreis (1) ununterbrochen ein drittes Signal (s3) erzeugt und das genannte dritte Signal (s3) in jedem Zeitpunkt den Wert der höchsten Spannung der genannten ersten und zweiten Signales (s1, s2) im Moment, in dem das dritte Signal (s3) erzeugt wird, annimmt;
**dadurch gekennzeichnet, dass**
der genannte erste Segmentationsschaltkreis (1) ununterbrochen ein viertes Signal (s4) erzeugt und das genannte vierte Signal (s4) in jedem Zeitpunkt den Wert der niedrigsten Spannung der genannten ersten und zweiten Signales (s1, s2) im Moment, in dem das vierte Signal (s4) erzeugt wird, annimmt;
die genannten drittes und viertes Signal (s3, s4) an betreffende Eingänge eines zweiten Segmentationsschaltkreises (2) für eine Segmentation der genannten dritten und vierten Signales (s3, s4) gekoppelt sind;
das genannte zweite Segmentationsschaltkreis (2) ein Positionssignal (so) erzeugt und aus einem Schaltkteis (21) zur Erzeugung eines Ladestromes besteht,
wobei der genannte Schaltkteis (21) zur Erzeugung des Ladestromes aus

einer Kette von n Widerständen (21r1, ... 21r(n-1), 21rn), wobei n eine ganze Zahl ist, mit einem Gesamtwiderstand R und einem Gesamtwider-

stand von $R.\sin(\frac{\pi}{4}.\frac{i}{n})$ von i niedrigsten Wi-

derständen (21r1, ..., 21ri), wo i eine ganze Zahl ist, und das genannte dritte Signal (s3) an eine obere Klemme der genannten Kette von n Widerständen (21r1, ... 21r(n-1), 21rn) gekoppelt ist;
einer Vielzahl von Komparatoren (21c1, ... 21c(n-2), 21c(n-1)),
wobei jede Zwischenklemme zwischen den benachbarten Widerständen der genannten Kette von n Widerständen (21r1, ... 21r(n-1), 21in) an eine betreffende obere Klemme der genannten Vielzahl von Komparatoren (21c1, ... 21c(n-2), 21c(n-1)) gekoppelt ist;
einer Vielzahl von Stromgeneratoren (21dg1, ... 21cg(n-2), 21cg(n-1), 21 cgn), die an eine Speisespannung (Vdd) angeschlossen sind, durch das dritte Signal (s3) gesteuert werden und genannte gewichtete Ströme erzeugen, die durch einen Ausgang (Uc) des genannten Schaltkteises (21) zur Erzeugung des Ladestromes gezogen werden;
der genannte Ausgang (Uc) des genannten Schaltkteises (21) zur Erzeugung des Ladestromes ist an niedrige Klemmen von jedem der genannten Vielzahl von Komparatoren (21c1, ... 21c(n-2), 21c(n-1)) angeschlossen;
einer Vielzahl von betreffenden Schaltern (21s1, ... 21s(n-2), 21s(n-1)), die für jedes Zeitintervall vom entsprechenden Stromgenerator die genannten gewichteten Ströme zum Ausgang (Uc) des genannten Schaltkteises (21) zur Erzeugung des Ladestromes übertragen;
und die genannten gewichteten Ströme werden jedesmal durch ein Ausgangssignal des genannten entsprechenden Komparators so gesteuert, dass der betreffende Schalter öffnet, als die Spannung am Ausgang (Uc) des genannten Schaltkteises (21) zur Erzeugung des Ladestromes die Spannung der entsprechenden Zwischenklemme der genannten Kette von n Widerständen (21r1, ... 21r(n-1), 21rn) erreicht;
der genannte Schaltkteis (21) zur Erzeugung des Ladestromes funktioniert, um den genannten Ladestrom zu erzeugen, damit ein kosinusförmiger Ladestrom mit Ladezyklen gleicher Dauer für Ladung eines Kondensators (22) gebildet wird und die genannten Zeitintervalle definierenden Randpunkte (0, Uc(t1), Uc(t2) ...) solche Ladestromwerte haben, dass sie genannten kosinusförmigen Ladestrom bilden;

besteht;
der genannte zweite Segmentationsschaltkreis (2) weiterhin aus

dem genannten Kondensator (22), dessen obere Klemme an den genannten Ausgang (Uc) des genannten Schaltkteises (21) zur Erzeugung des Ladestromes angeschlossen ist;

einem adaptiven Zeitschalter (23), der den genannten Kondensator (22) jedesmal, wenn die genannte Spannung am Ausgang (Uc) des genannten Schaltkteises (21) zur Erzeugung des Ladestromes die Momentanspannung des dritten Signales (s3) erreicht, entladet;

und einem weitereren Komparator (24), der das genannte Positionssignal (so) erzeugt und dessen obere Klemme die Ausgangsspannung am Ausgang (Uc) des genannten Schaltkteises (21) zur Erzeugung des Ladestromes und dessen niedere Klemme das genannte vierte Signal (s4) erhält;
besteht.

2. Schaltkreis zur Positionsbestimmung nach Anspruch 1, in welchem eine niedrigste Klemme der genannten Kette von n Widerständen (21r1, ... 21r (n-1), 21rn) und eine niedere Klemme des genannten Kondensators (22) an eine Referenzspannung (Uref), die einem Durchschnittswert des genannten ersten Signales (s1) oder des genannten zweiten Signales (s2) gleicht, angeschlossen sind.

3. Schaltkreis zur Positionsbestimmung nach Anspruch 2, in welchem die Kapazität des genannten Kondensators (22) und die gewichteten Ströme dermassen eingestellt werden, dass ein Zeitintervall zwischen zwei hintereinander folgenden Entladungen des genannten Kondensators (22) wenigstens um zwei Grössenordnungen kürzer von der Periode des genannten ersten Signales (s1) oder des genannten zweiten Signales (s2) ist.


**Revendications**

1. Circuit de détermination de position au moyen d'un premier signal (s1), de forme sinusoïdale, et d'un deuxième signal (s2), de forme cosinusoïdale,

lesdits premier et deuxième signaux (s1, s2) étant couplés aux entrées respectives d'un premier circuit de segmentation (1) pour une première segmentation desdits premier et deuxième signaux (s1, s2),
ledit premier circuit de segmentation (1) générant de manière ininterrompue un troisième signal (s3), ledit troisième signal (s3) prenant la valeur de la tension la plus élevée, à tout instant, desdits premier et deuxième signaux (s1, s2) au moment auquel le troisième signal (s3) est généré ;
**caractérisé en ce que**
ledit premier circuit de segmentation (1) génère de manière ininterrompue un quatrième signal (s4), ledit quatrième signal (s4) prenant la valeur de la tension la plus faible, à tout instant, desdits premier et deuxième signaux (s1, s2) au moment auquel le quatrième signal (s4) est généré ;
lesdits troisième et quatrième signaux (s3, s4) sont couplés aux entrées respectives d'un deuxième circuit de segmentation (2) pour une segmentation desdits troisième et quatrième signaux (s3, s4) ;
ledit deuxième circuit de segmentation (2) génère un signal de position (so) et consiste en un circuit de génération de courant de charge (21) pour générer un courant de charge,
ledit circuit de génération de courant de charge (21) consistant en
une chaîne de n résistances (21r1, ... 21r(n-1), 21rn), où n est un entier, ayant une résistance totale R et dans laquelle la résistance totale des i résistances les plus faibles (21r1, ..., 21ri), où i est un entier, est égale à $R.\sin\left(\dfrac{\pi}{4}.\dfrac{i}{n}\right)$

et ledit troisième signal (s3) est couplé à une borne supérieure de ladite chaîne de n résistances (21r1, ... 21r(n-1), 21n);
une pluralité de comparateurs (21c1, ... 21c(n-2), 21c(n-1)),
chaque borne intermédiaire entre des résistances adjacentes de ladite chaîne de n résistances (21r1, ... 21r(n-1), 21rn) étant couplée à une borne supérieure respective du comparateur respectif de ladite pluralité de comparateurs (21c1, ... 21c(n-2), 21c(n-1)) ;
une pluralité de générateurs de courant (21cg1, ... 21cg(n-2) ; 21cg(n-1), 21cgn) qui sont connectés à une tension d'alimentation (Vdd), qui sont commandés par le troisième signal (s3) et qui génèrent des courants pondérés, lesdits courants pondérés étant prélevés par l'intermédiaire d'une sortie (Uc) dudit circuit de génération de courant de charge (21) ;
ladite sortie (Uc) dudit circuit de génération de courant de charge (21) est connectée aux bornes inférieures de chacun de ladite pluralité de comparateurs (21c1, ... 21c(n-2), 21c(n-1)) ;
une pluralité de commutateurs (21s1, ... 21s(n-2), 21s(n-1)) respectifs, transférant lesdits courants pondérés à ladite sortie (Uc) dudit circuit de génération de courant de charge (21) pendant chaque intervalle de temps à partir du générateur de courant correspondant ;
et lesdits courants pondérés sont à chaque fois commandés par un signal de sortie dudit comparateur correspondant de manière à ce que le commutateur respectif s'ouvre lorsque la tension à la sortie (Uc) dudit circuit de génération de courant de charge (21) atteint la tension de la borne intermédiaire correspondante de ladite chaîne de n résistances (21r1, ... 21r(n-1), 21rn);

ledit circuit de génération de courant de charge (21) fonctionne pour produire ledit courant de charge pour former un courant de charge de forme cosinusoïdale ayant des cycles de charge de même durée pour charger un condensateur (22), et les points de frontière (0, Uc(t1), Uc (t2) ...) définissant lesdits intervalles de temps ont des valeurs de courant de charge telles que ledit courant de charge de forme cosinusoïdale est formé ;

ledit deuxième circuit de segmentation (2) consiste en outre en ledit condensateur (22), une borne supérieure dudit condensateur (22) étant couplée à ladite sortie (Uc) dudit circuit de génération de courant de charge (21) ;

un registre d'horloge adaptatif (23) déchargeant ledit condensateur (22) à chaque fois que ladite tension à la sortie (Uc) dudit circuit de génération de courant de charge (21) atteint la tension instantanée du troisième signal (s3) ;

et un autre comparateur (24) générant ledit signal de position (so), une borne supérieure dudit autre comparateur (24) reçoit la tension de sortie à la sortie (Uc) dudit circuit de génération de courant de charge (21) et une borne inférieure dudit autre comparateur (24) reçoit ledit quatrième signal (s4).

2. Circuit de détermination de position selon la revendication 1, dans lequel une borne la plus basse de ladite chaîne de n résistances (21r1, ... 21r(n-1), 21rn) et une borne inférieure dudit condensateur (22) sont connectées à une tension de référence (Uref), qui est égale à la valeur moyenne dudit premier signal (s1) ou dudit deuxième signal (s2).

3. Circuit de détermination de position selon la revendication 2, dans lequel la capacitance dudit condensateur (22) et les courants pondérés sont ajustés de manière à ce qu'un intervalle de temps entre deux décharges successives dudit condensateur (22) soit plus court d'au moins deux ordres de grandeur qu'une période dudit premier signal (s1) ou dudit deuxième signal (s2).

Fig. 1

Fig. 2

Fig 3.

Fig. 4

Fig. 5

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 10014056 A1
- DE 19544948 A1